# EUROPEAN PATENT APPLICATION

(11) **EP 1 273 421 A2**
(43) Date of publication of application: **08.01.2003**
(21) Application number: 02013417.7
(22) Date of filing: 13.06.2002
(51) Int. Cl.: B29C 44/44, B29C 44/34

(54) **Method for treating foamed plastic particles that are present in pourable form and device for carrying out said method**

(30) Priority: 05.07.2001 DE 10132494
(71) Applicant: DMT GmbH, Feinwerktechnische Komplettlösungen, 71088 Holzerlingen (DE)
(72) Inventor: Kopp, Siegfried Helmut, 71272 Renningen (DE)
(74) Representative: Borchert, Uwe Rudolf, Dipl.-Ing.

(57) **Abstract**

The invention pertains to a method for treating foamed plastic particles 32 that are present in pourable form, as well as a device for carrying out the method. The invention is characterized by the fact that the foamed plastic particles 32 are reduced in volume in an evacuated environment and then introduced into a mold 10, 34, 46, 52, 56, in which the foamed plastic particles 32 are subsequently restored toward their original outer shape in a non-evacuated environment.

## Description

### Technical Field

The invention pertains to a method for treating foamed plastic particles with a closed-cell structure which are present in pourable form, as well as a device for carrying out the method.

### Background

Known foamed plastic particles have open or closed cells that are distributed over their entire mass, i.e., the foamed plastic particles are loosened by gas bubbles in the framework substance. The bulk density of the foamed plastic particles consequently is lower than that of the framework substance. This means that foamed plastic particles of this type are two-phase systems that consist of a solid, namely the framework substance, and a gas. The solid usually consists of a polymer, and the gas usually consists of an expanding agent.

Foamed plastic particles of this type are used for manufacturing molded parts with arbitrary geometries, for example, as disclosed in EP 0 546 211. In this case, polystyrene, polyethylene and polypropylene are used for manufacturing the foamed plastic particles. The foamed plastic particles are referred to as expanded polystyrene, expanded polypropylene and extended polyethylene. Common aspects of these materials are the closed-cell structure, the manufacturing principle, the processing and, in part, the application. The remaining differences in the application and in the manufacturing and processing method are caused by the base polymer.

The morphology of the foamed plastic particles, i.e., the size and the shape of the cells, is responsible for various properties. Open-cell foamed plastics have very good acoustic properties-sound insulation. However, this results in increased water absorption if the foamed plastic particles come in contact with water. The cushioning or restoring properties--compressive deformation test--are largely defined by the framework substance, in this case, by the elasticity and the rigidity, and by the percentage of closed cells.

For example, the foamed plastic particles can be manufactured in accordance with the impregnation method. In this case, purposefully manufactured small granulates are impregnated with an expanding agent in an aqueous suspension under pressure and at an elevated temperature inside a pressure chamber and expanded in an expansion vessel after a certain dwell time. The degree of expansion and consequently the bulk density of the foamed plastic particles can be adjusted with the concentration of the expanding agent and the impregnating temperature. The obtained foamed plastic particles are completely expanded.

These foamed plastic particles are currently processed into molded parts in accordance with essentially the same principle, namely in conventional molding machines, the pressure of which is designed for the respective material. In this case, the foamed plastic particles are transported into the tool cavity at the selected pressure via a filling device that contains filling injectors. After the filling process, the foamed plastic particles are welded to one another by means of steam. The molded part is then cooled with water such that part of the excess pressure is alleviated and a so-called core set is formed.

The steam pressure required for welding the individual foamed plastic particles to one another lies between 0.5 and 1 bar for expanded polystyrene, between 1.5 and 2 bar for expanded polyethylene and between 3.2 and 3.8 bar for expanded polypropylene. Modified expanded polypropylene (Neopolen P 8210) can be sufficiently welded with a pressure of 2.5 bar.

Expanded polystyrene and expanded polystyrene copolymers are CFC-free particles that contain an expanding agent. The foamed plastic particles of expanded polyethylene and expanded polypropylene are, however, available on the market in the expanded state without residual expanding agents in bulk densities between 11 and 80 g/cm³. The intended use is decisive in selecting the respective type of foamed plastic.

One disadvantage of known methods for treating foamed plastic particles that are present in pourable form is that the application options are limited with respect to the shape of the molded parts due to the tool construction.

Although foamed plastic particles have favorable properties for various fields of application, their use is currently impeded by the lack of an economical method.

### Summary Of The Invention

Consequently, the invention is based on the objective of disclosing a method for treating foamed plastic particles that are present in pourable form and a device for carrying out said method which make it possible to broaden the fields of application by eliminating the previously described disadvantages.

With respect to the method, this objective is attained by a method for treating foamed plastic particles with a closed-cell structure which are in a pourable form, comprising reducing the volume of the foamed plastic particles in an evacuated environment, introducing the reduced foamed plastic particles into a mold and restoring the foamed plastic particles toward their original outer shape in a non-evacuated environment. With respect to the device, the device is one suitable for performing the method. Other aspects are outlined in accordance with the dependent claims which disclose characteristics for realizing advantageous additional developments of the invention.

The invention is based on the notion that a reduction in size of the foamed plastic particles with a closed-cell structure by means of a vacuum significantly simplifies transport and introduction of the particles into a molding tool. The restoration of the foamed plastic particles and the thus produced composite of the foamed plastic particles and the mold that surrounds the foamed plastic particles can form of a unitary article with a broad palette of application options and construction options.

According to the invention, the foamed plastic particles are initially reduced in volume in an evacuated environment and then introduced into a mold, in which the foamed plastic particles are restored toward their original outer shape in a non-evacuated environment. The transport volume of the foamed plastic particles consequently can be reduced if they are transported and stored in an evacuated environment, in which their volume is reduced. Due to the delayed restoration of the foamed plastic particles toward their original outer shape, which is caused by their closed-cell structure, the smaller foamed plastic particles can be easily introduced into the mold, in which they are gradually restored toward their original outer shape.

This causes a unitary article consisting of the restored foamed plastic particles and the mold surrounding the foamed plastic particles to be formed. The non-positive mold engagement allows for ease in separation such that the article consisting of the mold and the foamed plastic particles can be divided. This is particularly advantageous with respect to the ability to recycle the article.

The foamed plastic particles have a closed-cell structure, i.e., the numerous gas cells in the foamed plastic are closed. The vacuum causes the gas to diffuse out of the cells such that the volume of the foamed plastic particles is reduced. The closed-cell structure ensures that the foamed plastic particles are not immediately restored to their original shape when they are removed from the evacuated environment, but rather gradually over a certain time period because the gas needs to diffuse back into the cells. This ensures the delayed restoration, wherein the closed-cell structure acts similar to a throttle.

In addition, the reduction in size of the foamed plastic particles in an evacuated environment ensures that the foamed plastic particles contain no residual moisture at all when they are subsequently introduced into the mold. This is particularly advantageous with respect to the interaction with electronic components.

Another advantageous aspect of the method according to the invention is that the foamed plastic particles which, after being introduced into the mold, form a unit together with the mold are not glued or otherwise connected to one another. In this case, only the aforementioned mold clamping and frictional connections are produced such that the foamed plastic particles can also be separated from one another.

If the foamed plastic particles have an open-cell structure, they may be used as acoustic insulation, as well as protection for transporting of components, as described further below.

Another significant advantage of the new method is low tool costs.

The foamed plastic particles consist, in particular, of an elastic foamed plastic, for example, expanded polypropylene, expanded polyethylene, expanded polystyrene and/or expanded polyurethane. This has the advantage that the foamed plastic particles can be easily manufactured with conventional methods. Certain properties of the unit consisting of the foamed plastic particles and the mold can be easily adjusted by choosing corresponding mixing ratios of different foamed plastic particles on one hand and by choosing the corresponding material for the mold on the other hand.

The deformation and the restoration can be achieved most easily if the foamed plastic particles essentially have a spherical or elliptical shape before they are reduced in size in the evacuated environment.

According to one embodiment of the invention, the mold is formed by a space that is closed except for a filling opening. This makes it possible to easily and rapidly introduce the foamed plastic particles into the mold, in which they are subsequently restored toward their original outer shape. If so required, the filling opening can be subsequently closed in order to form a homogeneous bond between the mold and the foamed plastic particles.

The restoration of the foamed plastic particles preferably causes a surface pressure to be exerted upon the inner surface of the mold. This provides additional construction options.

For example, components can now be arranged in a fixed fashion within the mold with the aid of the foamed plastic particles. This is realized by arranging at least one additional component in the mold before pouring in the evacuated foamed plastic particles. This additional component is then fixed in position by the interaction between the introduced foamed plastic particles being restored and the mold. For example, this makes it possible to embed printed circuit boards because they are rigidly embedded by the foamed plastic particles and also protected from wetness. If so required, ventilation tubes can be incorporated in order to cool the printed circuit support while it is in operation. This may, for example, be realized with perforated hoses or tubes with lattice-like walls.

According to one embodiment of the invention, the mold is formed by a component. In this case, the component may consist of a boarding, a housing, a housing wall or the like. The component is reinforced and consequently provided with an increased flexural strength, in particular, due to the interaction between the component and the foamed plastic particles being restored which exert a surface pressure upon the inner surface of the component, i.e., the mold.

The pourability is also improved, primarily due to the reduction in size of the foamed plastic particles in an evacuated environment. Consequently, it is proposed to introduce the foamed plastic particles into the mold by means of pouring. The pourability increases proportionally to the reduction in volume of the foamed plastic particles.

For example, if the mold is formed by a packaging container, components such as sensitive products can be stored in a protected fashion by introducing the foamed plastic particles into the packaging container.

The invention proposes to primarily utilize foamed plastic particles that have a bulk density of approximately 10-300 g/L before the evacuation. Due to this measure, the foamed plastic particles in connection with the mold can be used as a furniture filling, as a filling for cavities in automobiles or a tire filling, wherein the tire forms the mold in the latter instance. However, the method according to the invention may also be used for manufacturing a building insulation, for example, in-between boards. In addition, extruded profiles can be easily insulated, and sintered rotary parts can be simply provided with an insulation by filling them with the evacuated foamed plastic particles.

It would also be conceivable to realize the mold/foamed plastic particles unit in the form of a filter insert, e.g., for an exhaust air filter, if the mold is at least sectionally realized such that it is permeable to fluids.

According to one embodiment of the invention, a mold is used which has walls of a material that essentially is dimensionally stable.

Alternatively or supplementary thereto, a mold is used which has walls of a flexible material, wherein the maximum attainable outer shape is defined by the structure of the flexible material in connection with the surface pressure exerted by the foamed plastic particles being restored. For example, this makes it possible to easily manufacture seats or cushions.

In certain fields of application, e.g., electronic and/or electro-mechanical devices, it is practical to utilize non-conductive foamed plastic particles and/or a non-conductive mold. Alternatively, the foamed plastic particles are provided with a conductive surface resistance between 10⁴ and 10¹² ohms in order to prevent electrostatic charges.

### Brief Description Of The Drawings

Other advantages and characteristics of the invention are discussed in the following description of embodiments which refers to the figures. The figures show:
Figure 1, a perspective representation of a pump with trigger electronics containing foamed plastic particles according to a first embodiment of the invention;
Figure 2, a top view of Figure 1;
Figure 3, a cross section through a drywall element containing foamed plastic particles according to a second embodiment of the invention;
Figure 4, a partially sectioned perspective representation of a seat containing foamed plastic particles according to a third embodiment of the invention;
Figure 5, a perspective representation of a profile containing foamed plastic particles according to a fourth embodiment of the invention, and
Figure 6, a cross section through a molded part containing foamed plastic particles according to a fifth embodiment of the invention.

### Detailed Description Of The Invention

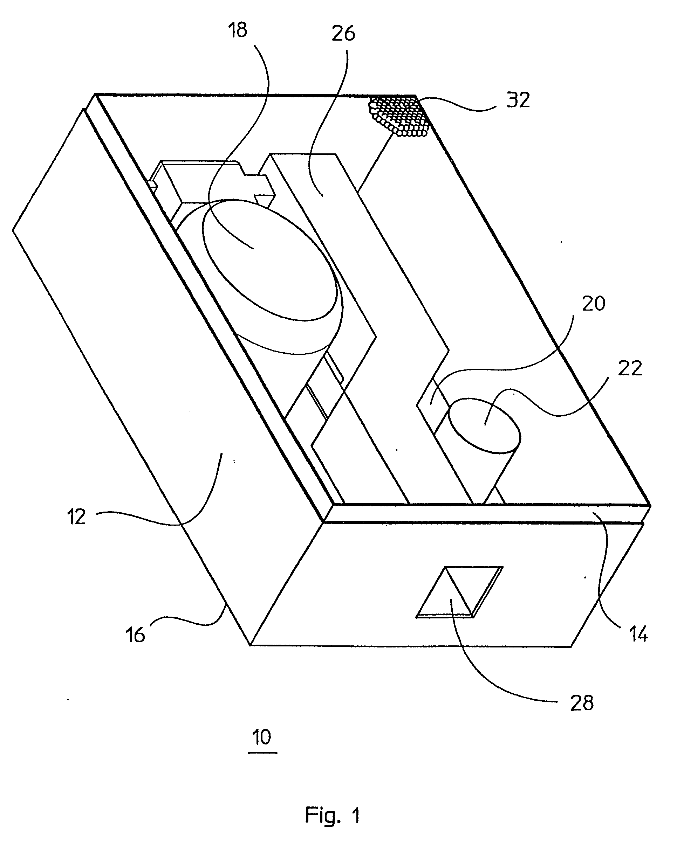

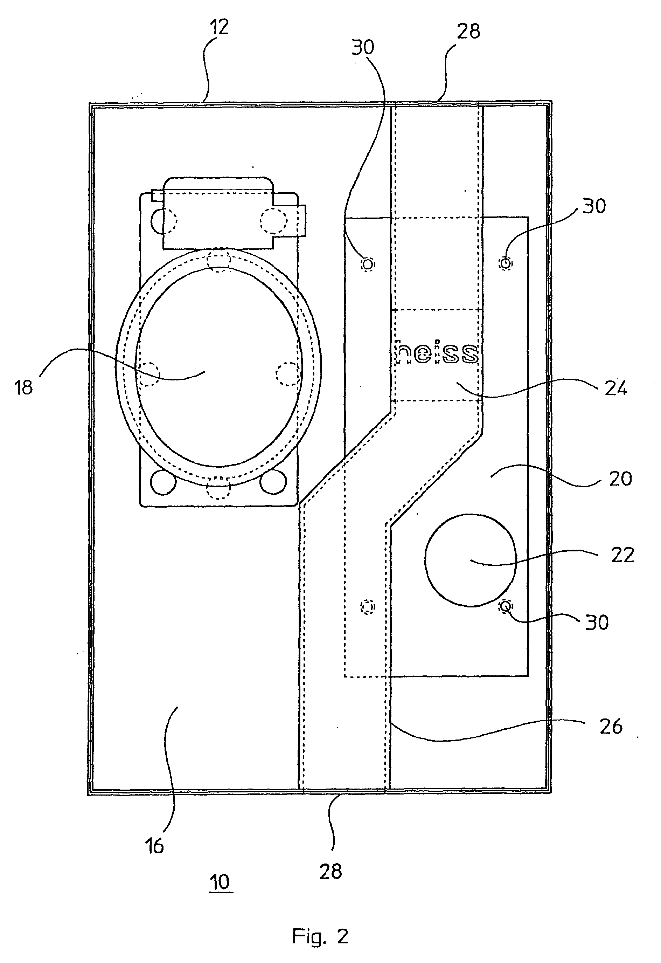

Figures 1 and 2 show a first embodiment of the invention in the form of a pump 10 with trigger electronics. The pump 10 consists of a housing 12 and a cover 14 that is arranged on the housing 12 and illustrated transparently in order to show the interior of the housing.

A pump motor 18 that is connected to a bottom 16 of the housing and provided with a printed circuit board 20 with trigger electronics, as well as an electronic component 22, is arranged in the housing 12. A ventilation channel 26 that respectively ends in air intake and air outlet openings 28 in the end faces of the housing 12 is provided to cool, in particular, a processor 24 arranged on the printed circuit board 20.

The printed circuit board 20 is connected to the bottom 16 of the housing by means of spacers 30.

The pump 10 contains foamed plastic particles 32 with a closed-cell structure--only symbolically illustrated--which are introduced as described below.

The foamed plastic particles 32 of spherical shape consist of an elastic foamed plastic, namely expanded polypropylene.

The volume of the foamed plastic particles 32 is reduced in an evacuated environment. For example expanded polypropylene beads with a bulk density of 15 to 65 kg/m³ may be treated at an absolute pressure of about 0.1 to 0.3 bar, for about two to eight hours. After the vacuum treatment, the beads are reduced in volume by from about 10 to 30%. After about another one to ten hours at ambient pressure, typically 1 bar, the beads gradually return to their original volume. The reduced particles are subsequently poured into the housing 12 of the pump 10. During this process, it is ensured that foamed plastic particles 32 which are sufficiently reduced in size are also introduced underneath the printed circuit board 20. This is made possible, among other things, by the spacers 30. The housing 12 is filled with foamed plastic particles 32 to a degree that depends on how intensely the foamed plastic particles 32 were reduced in size due to the evacuation and on how high the desired surface pressure exerted upon the inner wall of the housing 12 and the cover 14, as well as the components 18, 20, 22, 24, 26 arranged within the housing 12, should be. Subsequently, the cover 14 is rigidly connected to the housing 12. The foamed plastic particles 32 are now gradually restored toward their original outer shape since they are no longer situated in an evacuated environment. This causes an intimate composite of foamed plastic particles 32 to be gradually formed such that all components 18-26 are safely supported and fixed within the housing 12. The foamed plastic particles 32 protect the components from shocks and moisture, with the noise generated by certain parts, e.g., the pump motor 18, also being muffled.

In a simple way the composite consisting of foamed plastic particles 32 that are loosely pressed against one another and the components 16-28 consequently can be safely arranged in the housing 12 of the pump, wherein a sound insulation, as well as a shock absorption, are simultaneously realized.

The printed circuit board 20 may be rigid or flexible. In any case, the printed circuit board 20 is always reliably fixed because the foamed plastic particles act upon both sides of the printed circuit board. The ventilation channel 26 is able to fulfill its function of, in particular, cooling the processor 24 because it is not impaired by the foamed plastic particles 32.

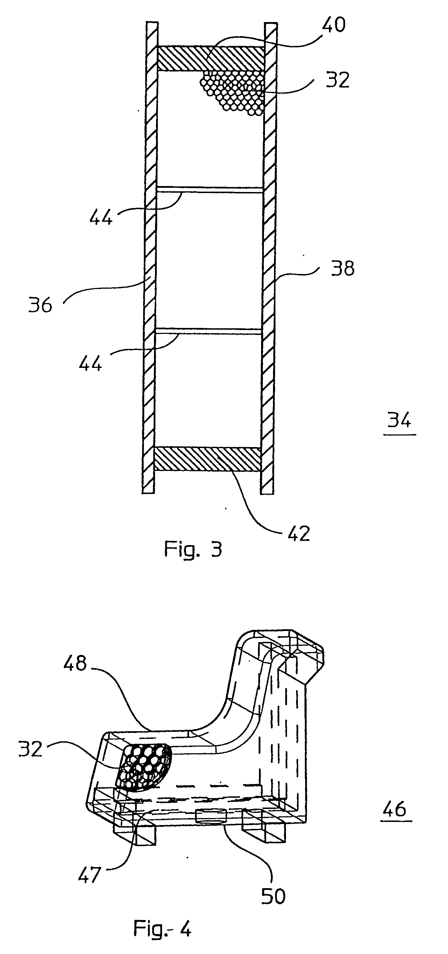

Figure 3 shows a second embodiment of the invention in the form of a cross section, namely through a drywall element 34 that consists of two wall parts 36 and 38 that are spaced apart from one another, two crossbeams 40 and 42 and coupling elements 44. The crossbeam 40 connects the upper region of the two wall parts 36 and 38, and the crossbeam 42 connects the lower region of the two wall parts 36 and 38. The crossbeams hold the wall parts 36 and 38 at a predetermined distance from one another.

Two coupling elements 44 are arranged between the crossbeams 40 and 42, wherein said coupling elements also extend transversely, i.e., the coupling elements are aligned parallel to the crossbeams 40 and 42. The coupling elements 44 absorb tensile forces and prevent the wall parts 36 and 38 from moving apart from one another.

Foamed plastic particles 32 with a closed-cell structure which were reduced in size in an evacuated environment are introduced into the intermediate space between the wall parts 36 and 38. The crossbeams 40 and 42 limit the top and the bottom of the intermediate space. In addition, posts that extend perpendicular to the crossbeams 40 and 42 and are not visible in this figure are provided, wherein said posts also limit the intermediate space and form the end faces.

This intermediate space is filled with the foamed plastic particles 32 that were reduced in size in an evacuated environment to a degree that corresponds to the desired surface pressure to be exerted upon the inner surface of the wall parts 36 and 38, the crossbeams 40 and 42 and the posts.

In this case, the foamed plastic particles 32 serve as an insulating material, as well as a reinforcing material. The reinforcement is achieved due to the surface pressure exerted upon the inner surfaces of the wall element 34 by the expanding foamed plastic particles 32.

The crossbeams 40 and 42, as well as the not-shown posts, may consist of metal, wood or concrete. They form the base framework of the drywall element 34. The wall parts 36 and 38 may consist of plywood, plaster, plasterboard or solid wood and are carried by the base framework.

Another embodiment in the form of a seat 46 is shown in Figure 4. The seat 46 contains a base frame 47 that is connected to a covering 48. The covering 48 is sewn in accordance with the shape of the seat 46. In the unfilled state, the covering 48 and the base frame 42 form a collapsed, unusable object.

The foamed plastic particles 32 with a closed-cell structure which were reduced in size in an evacuated environment are introduced into the covering 48 through an opening 50, namely in a quantity that corresponds to the desired surface pressure to be exerted upon the inner surface of the covering 48. Due to the restoration of the foamed plastic particles 32 to their original shape, the covering 48 now has the shape shown in Figure 4 because the foamed plastic particles 32 are no longer situated in an evacuated environment within the covering 48 and are restored to their original shape.

The opening 50 can be closed with a zipper. The shape of the seat 46 is defined by the design of the covering 48.

A comfortable seat can be easily manufactured in this fashion.

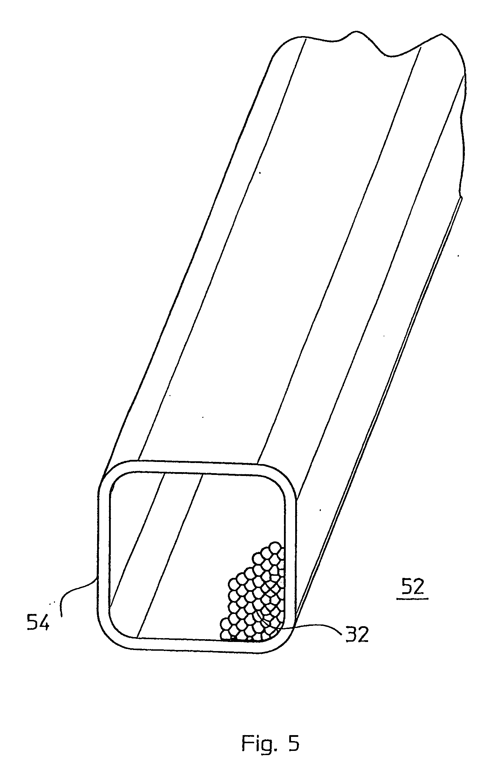

Figure 5 shows another embodiment of the invention in the form of a perspective representation of a profile 52. The profile 52 consists of an extruded shell 54 that is closed on its ends by means of sidewalls. The foamed plastic particles 32 are introduced into this profile 52 in the previously described fashion. A profile with high-strength properties that is reinforced by the foamed plastic particles 32 can be obtained by correspondingly metering the quantity of the foamed plastic particles 32 with a closed-cell structure. The reinforcement is achieved with the interior pressure, i.e., the surface pressure exerted upon the inner surface of the shell 54 and the sidewalls by the foamed plastic particles 32 being restored. The sidewalls are closed after the profile is filled with the foamed plastic particles 32 such that a closed space is formed and then gradually an intimate composite of foamed plastic particles 32 restored toward their original shape is formed.

The foamed plastic particles 32 also serve as insulation in this case. The extruded profile 52 may, for example, consist of aluminum or plastic.

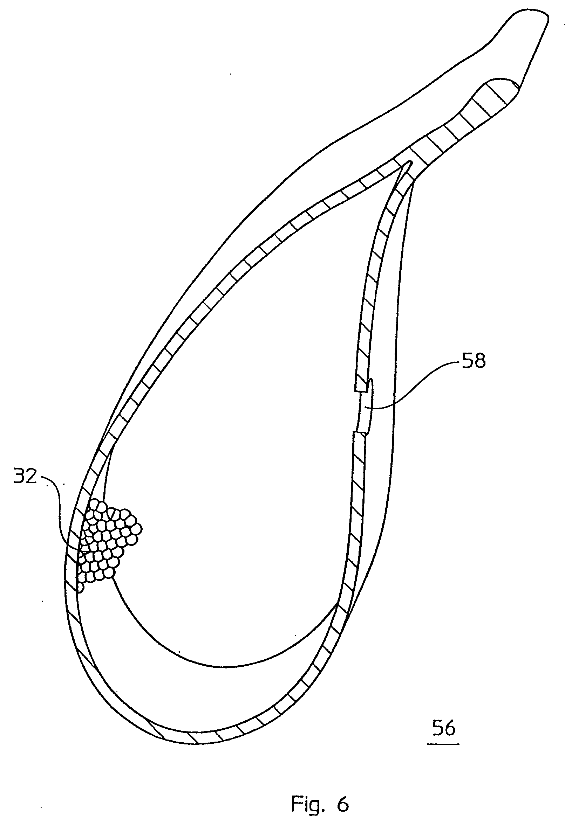

Figure 6 shows a fifth embodiment of the invention in the form of a blow-molded hollow body 56. The hollow body 56 may consist of metal, plastics or ceramics. The foamed plastic particles 32 with a closed-cell structure which were reduced in size in an evacuated environment are introduced as described above through a filling opening 58 in order to reinforce and insulate the hollow body, with the opening 58 subsequently being closed. The foamed plastic particles 32 are then restored toward their original outer shape such that an intimate composite of foamed plastic particles 32 is formed and a predetermined surface pressure is exerted upon the inner surface of the hollow body 56.

The invention is characterized by its simple procedure for reinforcing, insulating and realizing shock-absorption for hollow bodies, as well as for fixing and arranging components within a hollow body.

## Claims

1. A method for using foamed plastic particles (32) with a closed-cell structure which are in a pourable form for filling a mold, comprising:
a) reducing the volume of the foamed plastic particles in an evacuated environment
b) introducing the reduced foamed plastic particles into the mold (10, 34, 46, 52, 56)
c) restoring the foamed plastic particles toward their original outer shape in a non-evacuated environment.

2. The method according to Claim 1, wherein the foamed plastic particles (32) are made of an elastic foamed plastic.

3. The method according to Claim 1, wherein at least a portion of the foamed plastic particles (32) are made of expanded polypropylene.

4. The method according to Claim 1, wherein at least a portion of the foamed plastic particles (32) are made of expanded polyethylene.

5. The method according to Claim 1, wherein at least a portion of the foamed plastic particles (32) are made of expanded polystyrene.

6. The method according to Claim 1, wherein at least a portion of the foamed plastic particles (32) are made of expanded polyurethane.

7. The method according to Claim 1, wherein the foamed plastic particles (32) have a substantially spherical or elliptical shape before they are reduced in the evacuated environment.

8. The method according to Claim 1, wherein the mold (10, 34, 46, 52, 56) is defined by a space that is closed except for a filling opening (14, 50, 56).

9. The method according to Claim 1, wherein the restoration of the foamed plastic particles (32) causes a surface pressure to be exerted upon an inner surface of the mold (10, 34, 46, 52, 56).

10. The method according Claim 1 further comprising placing at least one additional component (20) into the mold (10, 34, 46, 52, 56) before introducing the evacuated foamed plastic particles (32), whereby said additional component is fixed in position by the subsequently introduced and restored foamed plastic particles (32).

11. The method according to Claim 1 wherein the mold consists of a component (10, 34, 46, 52, 56).

12. The method according to Claim 11, wherein the component (10, 34, 46, 52, 56) is in the form of a boarding.

13. The method according to Claim 11, wherein the component (10, 34, 46, 52, 56) is reinforced by the introduced and restored foamed plastic particles (32).

14. The method according to Claim 1, wherein the foamed plastic particles (32) are introduced by pouring into the mold (10, 34, 46, 52, 56).

15. The method according to Claim 1, wherein the foamed plastic particles (32) have a bulk density of approximately 10-300 g/L before the evacuation.

16. The method according to Claim 1, wherein the mold (10, 34, 46, 52, 56) has walls made of a material that is substantially dimensionally stable.

17. The method according to Claim 1, wherein the mold (10, 34, 46, 52, 56) has walls made of a flexible material, whereby a maximum attainable outer shape is defined by the structure of the flexible material in connection with a surface pressure exerted by the restored foamed plastic particles (32).

18. The method according to Claim 1, wherein the foamed plastic particles (32) are non-conductive and/or the mold (10, 34, 46, 52, 56) is non-conductive.

19. The method according to one of Claim 1, wherein the foamed plastic particles (32) have a conductive surface resistance of 10⁴-10¹² ohms.

20. A device for carrying out the method according to claim 1.

21. An article (10, 34, 46, 52, 56) having walls containing foamed plastic particles (32) that exert a surface pressure on an inner surface of at least part of the walls and form a rigid, but separable composite with the walls, wherein the article is produced in accordance with the method of Claim 1.
